# EUROPÄISCHE PATENTANMELDUNG

(11) **EP 4 819 824 A2**
(43) Veröffentlichungstag der Anmeldung: **07.10.2026**
(21) Anmeldenummer: 26165621.9
(22) Anmeldetag: 17.03.2026
(51) Int. Cl.: H10W 90/10, H02M 7/00, H10W 70/65, H10W 90/00

(54) **LEISTUNGSELEKTRONISCHES BAUTEIL**

(30) Priorität: 31.03.2025 DE 102025112577
(71) Anmelder: Volkswagen Aktiengesellschaft, 38440 Wolfsburg (DE)
(72) Erfinder: Michelsen, Steffen, 38440 Wolfsburg (DE); Pieper, Sven, 38440 Wolfsburg (DE); Holverscheid, Joshua, 38440 Wolfsburg (DE); Bayer, Christoph Friedrich, 38440 Wolfsburg (DE); Zimmermann, Matthias, 38440 Wolfsburg (DE); Lieker, Stephan, 38440 Wolfsburg (DE)

(57) **Zusammenfassung**

Die Erfindung betrifft ein leistungselektronisches Bauteil (10) umfassend einen Schaltungsträger (12), auf welchem mindestens ein Halbleiterelement (16) angeordnet ist, das über ein Verbindungselement (18) an einer Anbindungsstelle (20) mit einem elektrischen Kontaktelement (34) elektrisch leitend verbunden ist. Ein die Anbindungsstelle (20) brückenartig überragendes Sockelelement (22) ist mit einer Ausnehmung (24) derart angeordnet und ausgebildet, dass eine die Anbindungsstelle (20) überragende Kontaktierungsfläche (26) durch das Sockelelement (22) gebildet ist.

## Beschreibung

Die Erfindung betrifft ein leistungselektronisches Bauteil in einem Kraftfahrzeug, insbesondere einen Wechselrichter und/oder ein Powermodul. Insbesondere betrifft die Erfindung ein leistungselektronisches Bauteil, insbesondere einen Wechselrichter und/oder ein Powermodul für ein zumindest teilweise elektrisch angetriebenes Kraftfahrzeug.

Unter einem leistungselektronischen Bauteil wird insbesondere ein Element verstanden, das aus einem Schaltungsträger, insbesondere Substrat, gebildet ist, welcher bzw. welches mindestens zwei Lastkontakte, mindestens einen Halbleiterchip und mindestens ein Kontaktelement aufweist. Bei dem Kontaktelement kann es sich um einen Signalkontakt oder um einen Lastkontakt handeln. Der mindestens eine Halbleiterchip ist über mindestens ein elektrisch leitendes Verbindungselement mit dem mindestens einen Signalkontakt verbunden.

Der Schaltungsträger weist mindestens drei Schichten auf, wobei eine mittlere Schicht durch eine elektrisch isolierende Isolationsschicht gebildet ist und die untere Schicht und die obere Schicht jeweils durch mindestens eine elektrisch leitende metallische Schicht gebildet ist. Optional können auf einer oder mehreren der genannten Schichten Zusatzschichten aufgebracht sein, insbesondere metallische Zusatzschichten, um Oberflächen vollständig oder teilweise zu schützen und/oder um weitere Fügeprozesse durchführen zu können. Diesbezüglich wird insbesondere auf Silber-, Nickel- oder Goldschichten verwiesen.

Aus US 2013/0244490 A1 ist eine oberflächenmontierte elektrische Verbindung bekannt, die eine Schnittstelle zwischen Lötkugeln auf einem als "ball grid array" (BGA) bezeichneten BGA-Bauelement und einer Leiterplatte betrifft. Es ist kein Bezug zu einer Leistungselektronik erkennbar und nichts bezüglich der Gestaltung von Verbindungselementen zwischen einem Halbleiterelement und einem Kontaktelement offenbart.

Eine Herausforderung in der konstruktiven Auslegung sowie Fertigung leistungselektronischer Bauteile ist oft der hohe Integrationsgrad und somit ein damit verbundener knapper Bauraum. Zusätzlich ist Substratfläche oftmals - nach den Halbleitern - einer der wesentlichen Materialkostenpunkte, so dass ein Bedarf besteht, das leistungselektronische Bauteil möglichst platzsparend auszuführen. Diesem Ansatz steht im Speziellen die Anforderung gegenüber, dass oftmals Abstände zwischen elektrischen Anbindungsstellen und nahe liegenden Halbleiterelementen eingehalten werden müssen, um beispielsweise eine Werkzeugzugänglichkeit zu ermöglichen. Aus der Praxis sind daher insbesondere folgende Gestaltungen von Halbleiterelementen bekannt.

Zum einen ist es möglich, durch eine entsprechende Auslegung und Planung die Abstände zwischen den Substratflächen vorzuhalten. Der Nachteil hieran ist jedoch, dass sich die Substratfläche substanziell vergrößert und dadurch zusätzliche Kosten für Substrat, optionale Umhüllung mit einer Vergussmasse und eine Kühlung anfallen.

Weiterhin ist aus der Praxis bekannt, eine weitere Substratebene in dem leistungselektronischen Bauteil bereitzustellen, so dass zusätzlicher Raum generiert wird. Der Nachteil an dieser Lösung besteht darin, dass sie einerseits eine hohe Fertigungskomplexität aufweist und andererseits auch die weitere Ebene gekühlt werden muss, und somit erhöhte Kosten anfallen.

Ferner ist es denkbar, die Dicken der verwendeten Kontaktelemente, insbesondere Drahtdicken, zu reduzieren, so dass weniger Fläche für eine Kontaktierung benötigt wird. Hierdurch und insbesondere durch geringere Drahtdicken sinkt auch die Stromtragfähigkeit, so dass lediglich geringere Stromstärken übertragen werden können. Dies schränkt das Anwendungsgebiet derartiger Bauelemente ein.

Der Erfindung liegt die Aufgabe zugrunde, ein leistungselektronisches Bauteil gemäß dem Oberbegriff von Anspruch 1 zur Verfügung zu stellen, das möglichst wenig Bauraum auf einem Schaltungsträger beansprucht.

Die Lösung der Aufgabe erfolgt erfindungsgemäß mit den Merkmalen der unabhängigen Ansprüche. Weitere praktische Ausführungsformen und Vorteile der Erfindung sind in Verbindung mit den abhängigen Ansprüchen beschrieben.

Das erfindungsgemäße leistungselektronische Bauteil, insbesondere ein Wechselrichter und/oder ein Powermodul, weist einen Schaltungsträger auf. Bei dem Schaltungsträger handelt es sich insbesondere um ein Substrat. Auf dem Schaltungsträger ist mindestens ein Halbleiterelement angeordnet. Bei dem Halbleiterelement kann es sich beispielsweise um Transistoren, insbesondere MOSFET, und/oder Leistungs-Dioden und/oder Temperatursensoren handeln.

Das Halbleiterbauelement ist über ein Verbindungselement an einer Anbindungsstelle mit einem elektrischen Kontaktelement elektrisch leitend verbunden. Bei dem Verbindungselement kann es sich beispielsweise, jedoch nicht einschränkend, um einen Bonddraht oder Ribbon handeln. Bevorzugt handelt es sich bei dem Kontaktelement um einen Signal- oder Lastkontakt. Lastkontakte dienen üblicherweise der Übertragung hoher elektrischer Ströme und Spannungen innerhalb des leistungselektronischen Bauteils und zum Anschluss an andere (externe Leistungs-)Komponenten. Signalkontakte hingegen übertragen üblicherweise Steuer-, Überwachungs- und Messsignale, die für den sicheren und effizienten Betrieb des leistungselektronischen Bauteils erforderlich sind.

Ein die Anbindungsstelle brückenartig überragendes Sockelelement ist mit einer Ausnehmung derart über der Anbindungsfläche angeordnet und ausgebildet, dass eine die Anbindungsstelle überragende Kontaktierungsfläche durch das Sockelelement gebildet ist. Hierbei kann unter dem Begriff "brückenartig überragendes Sockelelement" im Sinne der Erfindung verstanden werden, dass das Sockelelement durch die Ausnehmung einen Zwischenraum an einer Unterseite aufweist, in dem die Anbindungsstelle angeordnet ist und wo - im montierten Zustand des Sockelelements - die elektrische Verbindung des Halbleiterelements mit dem elektrischen Kontaktelement erfolgt. Beispielsweise kann das Sockelelement auf das Substrat gefügt sein, insbesondere durch Ultraschallschweißen, Sintern oder Löten. Ferner weist das Sockelelement vorzugsweise ein elektrisch leitfähiges Material, beispielsweise Kupfer oder Aluminium auf.

Durch die vorstehend genannte Anordnung kann in vorteilhafter Weise eine Anordnung auf dem leistungselektronischen Bauteil ermöglicht werden, bei der sich das Verbindungselement einseitig mit der abgehenden Schnittstelle (dem Sockelelement) überschneidet. Hierdurch wird der Platzbedarf für die Anbindungsstelle des Verbindungselements effektiver als im Stand der Technik genutzt, was sich in einem reduzierten Platzbedarf widerspiegelt.

Gemäß einer praktischen Ausführungsform weist das Sockelelement mindestens zwei Teilelemente auf. In einem auf dem Schaltungsträger angeordneten Zustand des Sockelelements ist ein unmittelbar auf der Anbindungsstelle angeordnetes Teilelement massiv und ein auf dem Teilelement angeordnetes weiteres Teilelement mit der Ausnehmung ausgebildet. Aufgrund der räumlichen Anordnung wird das massive Teilelement nachfolgend auch als unteres Teilelement und das darauf angeordnete Teilelement als oberes Teilelement bezeichnet. Vorzugsweise ist das Verbindungselement auf dem unteren Teilelement angeordnet und verbindet dieses elektrisch mit dem Halbleiterbauelement. Das obere Teilelement überragt das Verbindungselement durch die Ausnehmung wie bereits erwähnt brückenartig.

Der Vorteil dieser Ausführungsform kann darin gesehen werden, dass durch die Anbindung des Verbindungselements auf dem Teilelement, welches unmittelbar auf der Anbindungsstelle angeordnet ist, eine höhere Lage des Verbindungselements ermöglicht ist, wodurch prozesssicher weitere Komponenten des leistungselektronischen Bauteils "überspannt" werden können. Ergänzend ist hierdurch eine Isolationsstrecke vergrößert und die Komponenten des elektronischen Bauteils können enger und somit platzsparender verbaut werden. Außerdem ist es möglich, das obere Teilelement des Sockelelements mit geringstmöglichem Aufwand an unterschiedlichste abgehende Schnittstellen anzupassen.

In einer praktischen Ausführungsform unterscheiden sich die mindestens zwei Teilelemente in ihrem Material. Dies bedeutet insbesondere, dass das erste Teilelement ein erstes Material und das zweite Teilelement ein zweites Material aufweist, wobei das erste Material und das zweite Material unterschiedlich sind. Beispielsweise kann das untere Teilelement Aluminium aufweisen oder aus Aluminium bestehen, während das obere Teilelement Kupfer aufweist oder aus Kupfer besteht. Die Ausgestaltung der beiden Teilelemente durch unterschiedliche Materialien ermöglicht eine Anpassung an verschiedene Einsatzszenarien und wirkt sich ferner vorteilhaft hinsichtlich auftretender Kosten und/oder Herstellungsvorgaben aus. Beispielsweise kann das untere Teilelement auf die Anbindungsstelle geklebt werden, während das obere Teilelement mittels Reibschweißen oder Laserschweißen angeordnet wird.

Von Vorteil kann es ferner sein, wenn gemäß einer praktischen Ausführungsform das Sockelelement ein Ausrichtelement zur winkelrichtigen Ausrichtung des Verbindungselements an der Anbindungsstelle aufweist. Eine winkelrichtige Ausrichtung des Verbindungselements hat den Vorteil, dass eine präzise Verbindung mit den Halbleiterelementen hergestellt wird. Insbesondere werden hierbei mechanische Spannungen vermieden, was die Lebensdauer der elektrischen Verbindung erhöht.

Gemäß einer alternativen praktischen Ausführungsform ist das Sockelelement monolithisch ausgebildet. Vorzugsweise weist das monolithische Sockelelement ebenfalls die bereits erwähnte Ausnehmung auf. Unter dem Begriff "monolithisch" kann im Sinne der Erfindung verstanden werden, dass das Sockelelement einstückig, also "aus einem Guss", hergestellt ist. Diese Ausführungsform hat den Vorteil, dass lediglich ein Sockelelement auf der Anbindungsstelle angeordnet werden muss. Somit ist hierdurch eine einfachere und kostengünstigere Lösung erreicht.

Gemäß einer praktischen Ausführungsform weist das Sockelelement mehrere Sockelabschnitte mit jeweils einer Ausnehmung auf, wobei die Sockelabschnitte in einer Vertikalausrichtung des Sockelelements übereinander angeordnet sind. Hierbei können zur Ausbildung der mehreren Sockelabschnitte entweder mehrere Teilelemente der bereits vorstehend erwähnten Art übereinander angeordnet werden oder das ebenfalls bereits erwähnte monolithische Sockelelement mehrere Ausnehmungen aufweisen. Diese Ausführungsform ermöglicht eine Anbindung mehrerer Verbindungselemente an ein einzelnes Sockelelement und somit eine parallele Ansteuerung von zwei oder mehreren Halbleiterelementen, wodurch weiterer Bauraum eingespart wird.

In einer weiteren praktischen Ausführungsform weist das Sockelelement eine Beschichtung und/oder eine prozesstechnische Bearbeitung auf. Unter dem Begriff "prozesstechnische Bearbeitung" kann im Sinne der Erfindung die Anwendung von spezifischen Fertigungs- oder Verarbeitungsverfahren verstanden werden, die das Material des Bauteils so verändern, dass es die gewünschten mechanischen, thermischen oder elektrischen Eigenschaften erhält, um seine Funktion im Endprodukt zu erfüllen und somit eine höhere Leistung, Zuverlässigkeit und Langlebigkeit der Bauteile zu gewährleisten. Beispielsweise kann das aus Aluminium bestehende Sockelelement weiterverarbeitet werden, z.B. vernickelt oder mit einer Beschichtung versehen werden, um anschließend stoffschlüssig mit anderen Bauteilen und insbesondere mit bzw. auf der Anbindungsstelle und/oder dem weiteren Sockelelement verbunden zu werden.

Von Vorteil kann es ferner sein, wenn die Ausnehmung als Sackloch ausgebildet ist. Die Ausnehmung ist somit nicht als durchgehende Ausnehmung ausgebildet, sondern als angepasste Freimachung. Hierdurch kann mehr Kontaktfläche bei kraftintensiven Fügeverfahren zur Verfügung gestellt werden. Des Weiteren ermöglicht die Ausgestaltung als Sackloch eine höhere Festigkeit durch weniger Materialabtrag und bietet daher Vorteile hinsichtlich einer mechanischen Beanspruchung, mechanischen Schwingungen und Folgeprozessen.

Um die elektrische Kontaktierung des Sockelelements mit dem Halbleiterelement zu vereinfachen, ist das Verbindungselement als Kontaktfahne ausgebildet und an dem Sockelelement vormontiert. Mit anderen Worten ist das als Kontaktfahne ausgebildete Verbindungselement bereits vor der Montage auf der Anbindungsstelle, also auf dem leistungselektronischen Bauteil, an dem Sockelelement befestigt. Somit muss nur noch eine einseitige Kontaktierung, nämlich an dem Halbleiterelement, erfolgen, was den Kontaktierungsprozess vereinfacht. Ferner kann das Sockelelement mit der Kontaktfahne auch monolithisch gefertigt werden. Eine sockelseitige Anbindung des Verbindungselements entfällt somit. Alternativ kann das Verbindungselement auch als vormontiertes Kontaktband ausgebildet sein.

Um insbesondere einen mechanischen Schutz des leistungselektronischen Bauteils und vorzugsweise der elektrischen Kontaktierungen sicherzustellen, ist zumindest die Anbindungsstelle mit einer Vergussmasse vergossen. Bevorzugt ist das gesamte leistungselektronische Bauteil mit einer Vergussmasse vergossen, die als Umhüllung dient. Beispielsweise handelt es sich bei der Vergussmasse um ein Epoxidharz und/oder ein Silikonharz und/oder um eine thermoplastische Vergussmasse.

Es wird ferner ein Verfahren zum elektrischen Verbinden eines Halbleiterbauteils mit einem elektrischen Kontaktelement beschrieben, das Verfahren umfassend die folgenden Schritte:
a) Bereitstellen eines leistungselektronischen Bauteils umfassend einen Schaltungsträger auf welchem mindestens ein Halbleiterelement angeordnet ist;
b) elektrisches Kontaktieren eines Verbindungselements an einer Anbindungsstelle des Schaltungsträgers und optionales elektrisches Kontaktieren des Verbindungselements mit dem Halbleiterelement;
c) Anordnen eines Sockelelements auf dem Schaltungsträger derart, dass eine Ausnehmung des Sockelelements die Anbindungsstelle brückenartig überragt.

Weiterhin soll ein alternatives Verfahren zum elektrischen Verbinden eines Halbleiterbauteils mit einem elektrischen Kontaktelement beschrieben werden, das Verfahren umfassend die folgenden Schritte:
a) Bereitstellen eines leistungselektronischen Bauteils umfassend einen Schaltungsträger auf welchem mindestens ein Halbleiterelement angeordnet ist;
b) Anordnen eines Teilelements eines Sockelelements auf dem Schaltungsträger;
c) elektrisches Kontaktieren eines Verbindungselements an einer Anbindungsstelle des Teilelements und optionales elektrisches Kontaktieren des Verbindungselements mit dem Halbleiterelement;
d) Anordnen eines weiteren Teilelements des Sockelelements auf dem Teilelement derart, dass eine Ausnehmung des weiteren Teilelements die Anbindungsstelle brückenartig überragt.

Weitere praktische Ausführungsformen der Erfindung sind nachfolgend im Zusammenhang mit den Zeichnungen beschrieben. Es zeigen:
- Fig. 1: eine schematische perspektivische Darstellung eines erfindungsgemäßen leistungselektronischen Bauteils auf dem ein Halbleiterelement angeordnet ist, das über ein Verbindungselement an einer Anbindungsstelle über ein Sockelelement mit einem elektrischen Kontaktelement elektrisch leitend verbunden ist;
- Fig. 2a-d: eine schematische Darstellung der Schritte zur Anordnung und elektrischen Verbindung des Sockelelements auf dem leistungselektronischen Bauteil;
- Fig. 3: eine schematische perspektivische Darstellung des leistungselektronischen Bauteils gemäß Fig. 1, das mit einer Vergussmasse vergossen ist; und
- Fig. 4: eine schematische perspektivische Darstellung eines Ausschnitts des leistungselektronischen Bauteils gemäß Fig. 1, auf dem ein alternatives Sockelelement angeordnet ist.

In den Figuren sind gleiche bzw. gleichwirkende Bauteile stets mit den gleichen Bezugszeichen dargestellt.

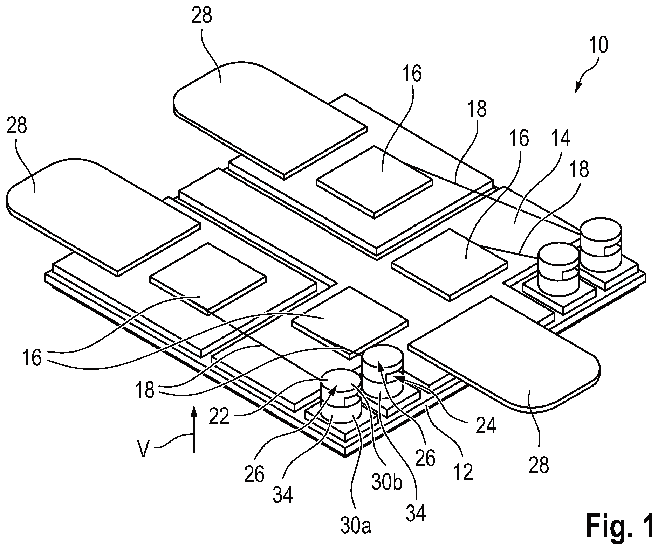

In Fig. 1 ist eine schematische und perspektive Darstellung eines erfindungsgemäßen leistungselektronischen Bauteils 10 gezeigt. Das leistungselektronische Bauteil 10 umfasst einen Schaltungsträger 12, bei dem es sich vorzugsweise um ein Substrat handelt. Ferner weist das leistungselektronische Bauteil 10 eine auf dem Schaltungsträger 12 angeordnete elektrisch leitende Substratschicht 14 auf. Auf dem Schaltungsträger 12 und insbesondere auf der elektrisch leitenden Substratschicht 14 ist ein Halbleiterelement 16 angeordnet. Im gezeigten Ausführungsbeispiel weist der Schaltungsträger 12 vier Halbleiterelemente 16 auf. Bei den Halbleiterelementen 16 kann es sich beispielsweise - jedoch nicht einschränkend - um Transistoren oder Temperatursensoren handeln.

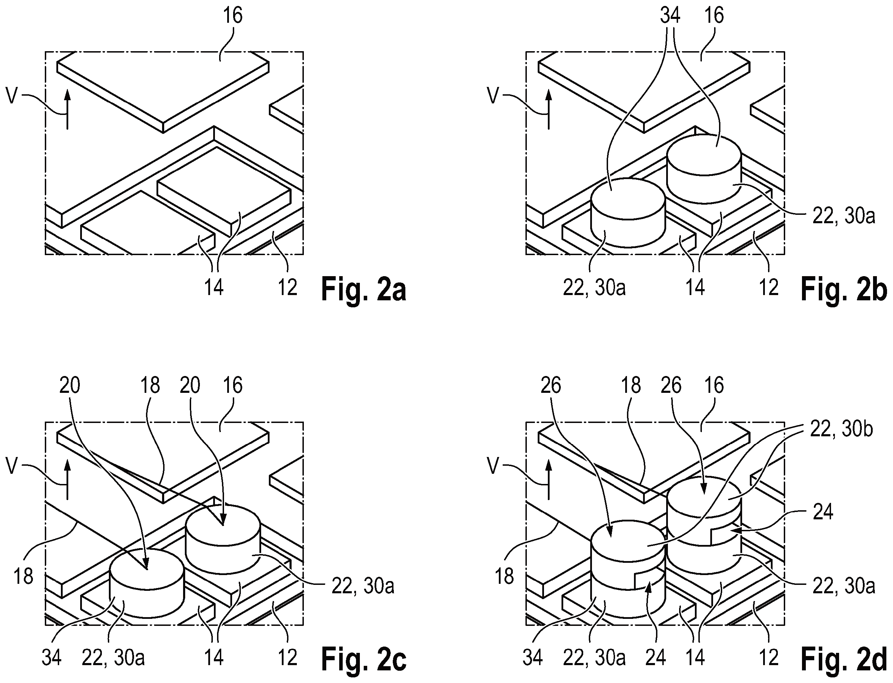

Des Weiteren ist jedes Halbleiterelement 16 über ein jeweiliges Verbindungselement 18 an einer Anbindungsstelle 20 (vgl. Fig. 2c) mit einem elektrischen Kontaktelement 34 elektrisch leitend verbunden. Bei dem Verbindungselement 18 handelt es sich im vorliegenden Ausführungsbeispiel um einen Bonddraht. Ergänzend weist das leistungselektronische Bauteil 10 noch elektrische Lastkontakte 28 auf, auf die jedoch aufgrund mangelnder Relevanz für die Erfindung nachfolgend nicht weiter eingegangen wird.

Des Weiteren weist das leistungselektronische Bauteil 10 ein die Anbindungsstelle 20 brückenartig überragendes Sockelelement 22 mit einer Ausnehmung 24 auf. Das Sockelelement 22 ist dabei derart auf dem Schaltungsträger 12 angeordnet und ausgebildet, dass eine die Anbindungsstelle 20 überragende Kontaktierungsfläche 26 durch das Sockelelement 22 gebildet ist. Hierbei weist das Sockelelement 22 zwei Teilelemente 30a, 30b auf, wobei ein unteres Teilelement 30a und ein oberes Teilelement 30b - jeweils in einer Vertikalausrichtung V betrachtet - vorgesehen ist. Die Ausnehmung 24 ist hierbei im gezeigten Ausführungsbeispiel jeweils in dem oberen Teilelement 30b ausgebildet.

Durch die brückenartige Ausgestaltung des Sockelelements 22, insbesondere des oberen Teilelements 30b, kann eine platzsparende Bauweise und Kontaktierung des Halbleiterelements 16 über das Sockelelement 22 erreicht werden. Durch die brückenartige Ausgestaltung zumindest des oberen Teilelements 30b kann die Anbindungsstelle 20 zuverlässig baulich überbrückt werden und eine Kontaktierungsfläche 26 an der Oberseite des Sockelelements 22, beispielsweise für externe Anschlüsse, realisiert werden.

Eine Kontaktierung neben dem Sockelelement 22, wie sie aus dem Stand der Technik bekannt ist, kann vermieden werden. Gleichzeitig werden jedoch vorgegebene und/oder geforderte Isolationsstrecken eingehalten.

In den Fig. 2a-2d ist der grundsätzliche Anordnungsprozess des in Fig. 1 beschriebenen Sockelelements 22 gezeigt. Fig. 2a zeigt den noch unbesetzten Raum der elektrisch leitenden Substratschicht 14 auf dem Schaltungsträger 12.

Auf diesem erfolgt dann die Anordnung des Sockelelements 22, insbesondere des unteren Teils 30a des Sockelelements 22, wie in Fig. 2b dargestellt. Dies kann beispielsweise mittels Ultraschallschweißen, Sintern oder Löten erfolgen.

Anschließend und wie in Fig. 2c gezeigt, erfolgt ein elektrisches Anbinden des Verbindungselements 18 an der Anbindungsstelle 20 auf der Oberseite des unteren Teilelements 30a. Da das Verbindungselement 18 vorzugsweise als Bonddraht ausgebildet ist, kann dieser Schritt beispielsweise durch ein Bondwerkzeug erfolgen. Das untere Teilelement 30a ist insoweit bei der in den Figuren 2a-2d gezeigten Ausführungsform das elektrische Kontaktelement 34.

Nach dem elektrischen Anbinden des Verbindungselements 18 wird ein oberes Teilelement 30b des Sockelelements 22 auf der Oberseite des unteren Teilelements 30a des Sockelelements 22 angeordnet. Das obere Teilelement 30b weist die Ausnehmung 24 auf, die sich brückenartig über die Anbindungsstelle 20 erstreckt. Die Oberseite des oberen Teilelements 30b dient dabei als Kontaktierungsfläche 26 für einen externen Anschluss.

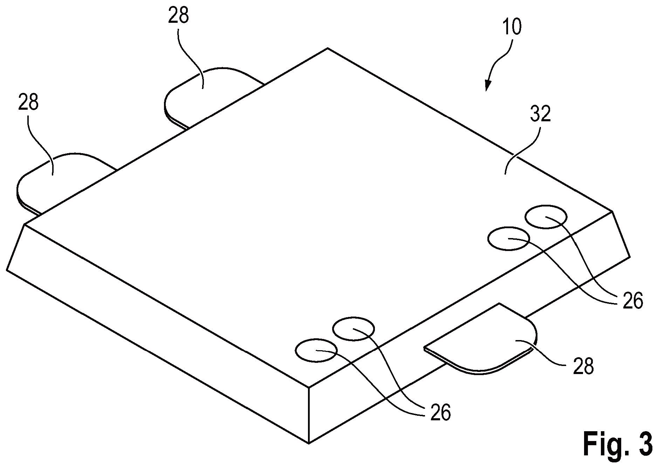

In Fig. 3 ist eine perspektivische Darstellung des in Fig. 1 gezeigten leistungselektronischen Bauteils 10 gezeigt. In Fig, 3 ist das gezeigte leistungselektronische Bauteil 10 jedoch vollständig von einer Vergussmasse 32 umhüllt, um die elektrischen und/oder elektronischen Komponenten des Schaltungsträgers 12 zu schützen. Um einen externen Anschluss zu ermöglichen, ragen lediglich die Lastkontakte 28 sowie die Kontaktierungsflächen 26 der Sockelelemente 22 aus der Vergussmasse 32 heraus bzw. sind frei von der Vergussmasse 32.

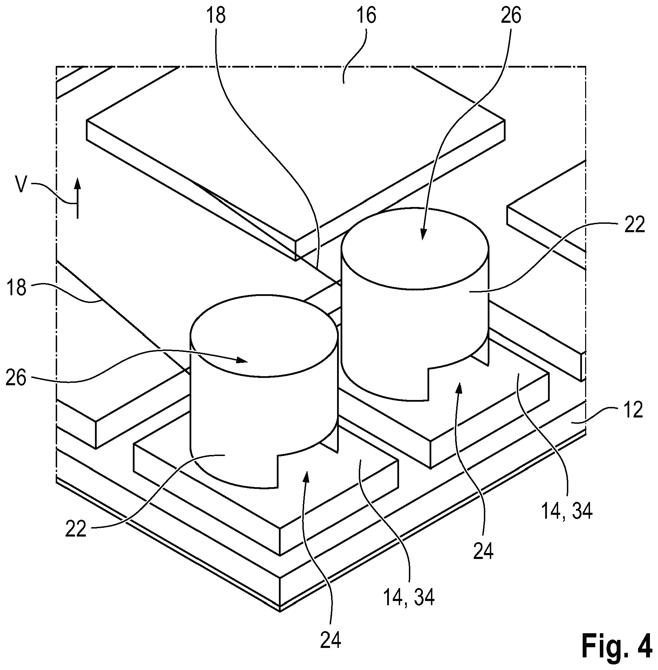

Eine alternative Ausgestaltung des Sockelelements 22 ist in Fig. 4 in einer schematischen perspektivischen Darstellung gezeigt. Im Wesentlichen entspricht die gezeigte Ausführungsform des leistungselektronischen Bauteils 10 der in Fig. 1 gezeigten Ausführungsform, so dass hinsichtlich der weiteren Komponenten auf die Ausführungen zur Fig. 1 Bezug genommen wird.

Der wesentliche Unterschied des Sockelelements 22 besteht darin, dass dieses einen monolithischen Aufbau aufweist. Das heißt, dass das Sockelelement 22 nicht wie in der in Fig. 1 gezeigten Ausführungsform zwei Teilelemente 30a, 30b aufweist. Vielmehr ist das Sockelelement 22 gemäß Fig. 4 einstückig ausgebildet. Diese alternative Ausführungsform hat sich hinsichtlich einer einfacheren Fertigung des Sockelelements 22 sowie einer vereinfachten Montage bzw. Anordnung des Sockelelements 22 auf der elektrisch leitenden Substratschicht 14 als vorteilhaft erwiesen. Bei der in Fig. 4 gezeigten Ausführungsform ist das elektrische Kontaktelement 34 durch die elektrisch leitende Substratschicht 14 gebildet, da das Verbindungselement 18 unmittelbar mit der elektrisch leitenden Substratschicht 14 elektrisch leitend verbunden ist.

Die in der vorliegenden Beschreibung, in den Zeichnungen sowie in den Ansprüchen offenbarten Merkmale der Erfindung können sowohl einzeln als auch in beliebigen Kombinationen für die Verwirklichung der Erfindung in ihren verschiedenen Ausführungsformen wesentlich sein. Die Erfindung kann im Rahmen der Ansprüche und unter Berücksichtigung der Kenntnisse des zuständigen Fachmanns variiert werden.

### Bezugszeichenliste

- 10: leistungselektronisches Bauteil
- 12: Schaltungsträger
- 14: elektrisch leitende Substratschicht
- 16: Halbleiterelemente
- 18: Verbindungselement
- 20: Anbindungsstelle
- 22: Sockelelement
- 24: Ausnehmung
- 26: Kontaktierungsfläche
- 28: Lastkontakte
- 30a: unteres Teilelement
- 30b: oberes Teilelement
- 32: Vergussmasse
- 34: elektrisches Kontaktelement

- V: Vertikalausrichtung

## Patentansprüche

1. Leistungselektronisches Bauteil (10) umfassend einen Schaltungsträger (12), auf welchem mindestens ein Halbleiterelement (16) angeordnet ist, das über ein Verbindungselement (18) an einer Anbindungsstelle (20) mit einem elektrischen Kontaktelement (34) elektrisch leitend verbunden ist,
**dadurch gekennzeichnet,**
**dass** ein die Anbindungsstelle (20) brückenartig überragendes Sockelelement (22) mit einer Ausnehmung (24) derart angeordnet und ausgebildet ist, dass eine die Anbindungsstelle (20) überragende Kontaktierungsfläche (26) durch das Sockelelement (22) gebildet ist.

2. Leistungselektronisches Bauteil (10) nach dem vorstehenden Anspruch, **dadurch gekennzeichnet, dass** das Sockelelement (22) mindestens zwei Teilelemente (30a, 30b) aufweist, insbesondere wobei in einem auf dem Schaltungsträger (12) angeordneten Zustand des Sockelelements (22) ein unmittelbar auf der Anbindungsstelle (20) angeordnetes Teilelement (30a) massiv und ein darauf angeordnetes weiteres Teilelement (30b) mit der Ausnehmung (24) ausgebildet ist.

3. Leistungselektronisches Bauteil (10) nach dem vorstehenden Anspruch, **dadurch gekennzeichnet, dass** die mindestens zwei Teilelemente (30a, 30b) sich in ihrem Material unterscheiden.

4. Leistungselektronisches Bauteil (10) nach Anspruch 1 oder 2, **dadurch gekennzeichnet, dass** das Sockelelement (22) ein Ausrichtelement aufweist, zur winkelrichtigen Ausrichtung des Verbindungselements (18) an der Anbindungsstelle (20).

5. Leistungselektronisches Bauteil (10) nach Anspruch 1, **dadurch gekennzeichnet, dass** das Sockelelement (22) monolithisch ausgebildet ist.

6. Leistungselektronisches Bauteil (10) nach einem der vorstehenden Ansprüche, **dadurch gekennzeichnet, dass** das Sockelelement (22) mehrere Sockelabschnitte mit jeweils einer Ausnehmung (24) aufweist, wobei die Sockelabschnitte in einer Vertikalausrichtung (V) des Sockelelements (22) übereinander angeordnet sind.

7. Leistungselektronisches Bauteil (10) nach einem der vorstehenden Ansprüche, **dadurch gekennzeichnet, dass** das Sockelelement (22) eine Beschichtung und/oder eine prozesstechnische Bearbeitung aufweist.

8. Leistungselektronisches Bauteil (10) nach einem der vorstehenden Ansprüche, **dadurch gekennzeichnet, dass** die Ausnehmung (24) als Sackloch ausgebildet ist.

9. Leistungselektronisches Bauteil (10) nach einem der vorstehenden Ansprüche, **dadurch gekennzeichnet, dass** das Verbindungselement (18) als Kontaktfahne ausgebildet ist und an dem Sockelelement (22) vormontiert ist.

10. Leistungselektronisches Bauteil (10) nach einem der vorstehenden Ansprüche, **dadurch gekennzeichnet, dass** zumindest die Anbindungsstelle (20) mit einer Vergussmasse (32) vergossen ist.
